(19) Europäisches Patentamt

European Patent Office

Office européen des brevets

(11) **EP 1 712 087 B1**

(12) **EUROPEAN PATENT SPECIFICATION**

(45) Date of publication and mention of the grant of the patent:
**10.03.2021 Bulletin 2021/10**

(21) Application number: **05712116.2**

(22) Date of filing: **26.01.2005**

(51) Int Cl.:
*G02B 5/18* (2006.01)          *G11B 7/135* (2012.01)

(86) International application number:
**PCT/US2005/002520**

(87) International publication number:
**WO 2005/072370 (11.08.2005 Gazette 2005/32)**

(54) **THIN CAMERA HAVING SUB-PIXEL RESOLUTION**

DÜNNE KAMERA MIT SUBPIXEL-AUFLÖSUNG

APPAREIL PHOTO MINCE A RESOLUTION SUBPIXELLAIRE

(84) Designated Contracting States:
**AT BE BG CH CY CZ DE DK EE ES FI FR GB GR HU IE IS IT LI LT LU MC NL PL PT RO SE SI SK TR**

(30) Priority: **26.01.2004  US 763396**
**08.04.2004  US 560273 P**
**27.09.2004  US 949807**

(43) Date of publication of application:
**18.10.2006  Bulletin 2006/42**

(60) Divisional application:
**11153126.5 / 2 315 448**

(73) Proprietor: **DigitalOptics Corporation**
**San Jose CA 95134 (US)**

(72) Inventors:
• **FELDMAN, Michael, R.**
**Huntersville, NC 28078 (US)**

• **TEKKOLSTE, Robert**
**Charlotte NC 28205 (US)**

(74) Representative: **Hanna Moore + Curley**
**Garryard House**
**25-26 Earlsfort Terrace**
**Dublin 2, D02 PX51 (IE)**

(56) References cited:
**EP-A- 1 215 729          EP-A1- 1 348 990**
**GB-A- 2 320 837          US-A- 5 568 197**
**US-A- 5 757 423          US-A- 5 760 832**
**US-A- 6 137 535          US-A1- 2002 122 124**
**US-A1- 2002 163 582     US-A1- 2002 181 126**
**US-B1- 6 611 289         US-B2- 6 632 701**

**Description**

BACKGROUND OF THE INVENTION

1. Field of the Invention

The present invention is directed to a thin camera. More particularly, the present invention is directed to a thin camera using color filters and/or having an increased field of view.

2. Description of Related Art

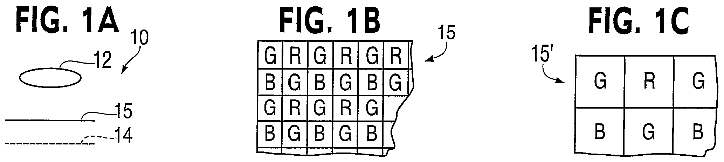

A conventional camera 10, shown in FIG. 1A includes a lens 12 with a focal length f and a detector array 14, having a plurality of pixels. To realize color imaging, an array of filters 15 having some pattern, typically with more green filters than red or blue filters, is provided. An example of the filter array 15 is shown in FIG. 1B. Each filter in the filter array 15 corresponds to a detector, or pixel, in the detector array 14. However, this camera is relatively thick.

One approach to realizing a thin camera with sufficient resolution involves scaling an imaging system of a conventional camera, e.g., an f/1 camera having a lens with a focal length f. Assume the focal plane has $n_x$ pixels or sensors of a size $p_x$ in the x-direction and $n_y$ pixels of size $p_y$ in the y-direction. The resolution is then defined as $1/p_x$ in the x-direction and $1/p_y$ in the y-direction. If $p_x$ and $p_y$ could be reduced by a desired scaling factor, thus keeping $n_x$ and $n_y$ the same, as noted above, then f could be reduced, while maintaining the resolution. However, this scaled down pixel size may be limited by availability and/or price of current sensors. Further, there is not enough power in such a scaled down system.

Another solution uses compound eye image capturing, the size of the lens being in accordance with a desired thinness of the camera. Each lens in the compound eye corresponds to a plurality of pixels, with the compound eye being selected so that spacing of the lenses is not an integral multiple of pixel spacing. Thus, each lens looks at different shifted images. The lenses used in the compound eye image capturing system generally have low resolution, for example a PSF equal or larger than the area of each pixel. A resolution greater than that of an individual sub-camera is achieved by combining the images from multiple cameras. For this solution, a color filter array 15' shown in FIG. 1C, has a color filter for each lens. Multiple lenses are used for each color and the images for each color combined. However, the use of compound eye image capturing is computationally intensive and it is difficult to achieve a resolution equal or close to that of the number of pixels in the sensor array for the entire composite image.

US2002/122124 A1 discloses an image sensing apparatus which can satisfactorily correct mis-registration among images, and can composite the images. To achieve this object, an image sensing apparatus includes: a plurality of apertures that receives external light from different positions: a plurality of image sensing units that outputs image signals obtained by independently receiving light that comes from an identical position of an object and is received via the plurality of apertures, and independently extracting predetermined color components for each received light; and a signal processing device that forms a signal that outputs an object image by mixing the image signals output from the plurality of image sensing units.; When it is determined that a predetermined. position deviation occurs between the image signals upon forming the signal that outputs the object image, the signal processing device corrects the predetermined position deviation. by a signal process, and forms the signal that outputs the object image

EP1348990 A1 discloses an image capturing lens to capture an image of an object provided, the image capturing lens includes an aperture diaphragm having an aperture through which an image is captured; a first lens having a positive refracting power, wherein both surfaces of the first lens are shaped in a convex form: a second lens having a negative refracting power, wherein an object-side surface of the second lens is shaped a concave form; and a third lens which is a meniscus lens whose convex surface faces toward the object side: wherein the aperture diaphragm, the firs lens, the second lens and the third lens are aligned in this order from the object side.

GB 2320837 A discloses a colour filter array and its processing circuit in which a vertical interpolation process is not needed, which can be used in a video camera, digital camera, colour scanner, or colour copier, is constituted such that the number of green colour filters is double the respective numbers of red and blue colour filters in order to make human colour recognition easy. The red and blue colour filters are places every four pixels and a green colour filter is placed every other pixel along each line of the image, for example defining a filter pattern consisting of R-G-B-G, G-R-G-B and B-G-R-G filter groups.

**SUMMARY OF THE INVENTION**

According to the present invention there is provided a camera according to claim 1.

BRIEF DESCRIPTION OF THE DRAWINGS

The above and other features and advantages of the present invention will become readily apparent to those of skill in the art by describing in detail embodiments thereof with reference to the attached drawings, in which:

FIG. 1A is a schematic side view of an imaging system in a conventional camera;
FIG. 1B is a plan view of a conventional color filter array for use with the conventional camera of FIG. 1A;
FIG. 1C is a plan view of another conventional color filter array;
FIG. 2A is a is a schematic perspective view of an imaging system in a camera according to an embodiment of the present invention;
FIGS. 2B to 2D are plan views of color filters according to embodiments of the present invention;
FIG. 2E is a schematic exploded side view of a macro-pixel/micro-pixel configuration for use in a micro-camera in an embodiment of the present invention;
FIGS. 3A and 3B are plan views of further color filters according to other embodiments of the present invention;

FIG. 4 is a schematic side view of an embodiment of the present invention including a mask adjacent to the lenses;

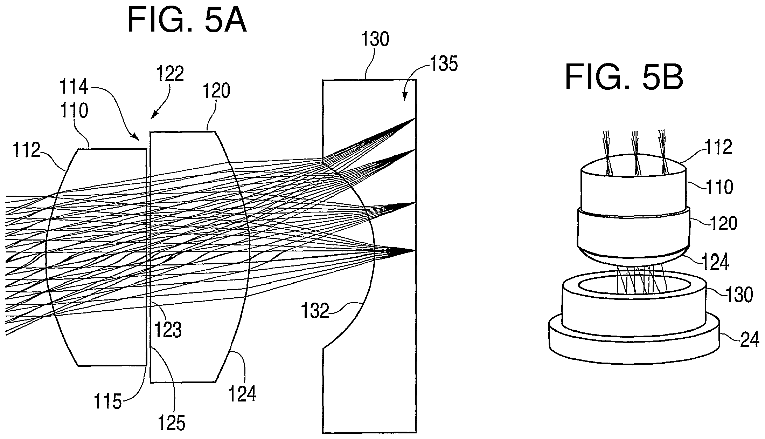

FIG. 5A is a schematic side view of a specific lens system for use with the present invention;
FIG. 5B is a schematic perspective view of the lens system of FIG. 7A;
FIG. 6A is a schematic top view of a sub-camera arrangement according to an embodiment of the present invention; and
FIG. 6B is a schematic top view of shifted images for a sub-camera of FIG. 6A.

DETAILED DESCRIPTION OF THE INVENTION

It will be understood that when a layer is referred to as being "on" another layer or substrate, it may be directly on the other layer or substrate, or intervening layers may also be present. Further, it will be understood that when a layer is referred to as being "under" another layer, it may be directly under, or one or more intervening layers may also be present. In addition, it will also be understood that when a layer is referred to as being "between" two layers, it may be the only layer between the two layers, or one or more intervening layers may also be present. Like numbers refer to like elements throughout.

A useful parameter in imaging systems is the f/# of the system, where f/# = f/D, where f is the focal length and D is the size of the aperture of the lens. In creating a thinner camera, while keeping the same f/# as for a conventional camera, when f is reduced, a commensurate reduction in D is needed.

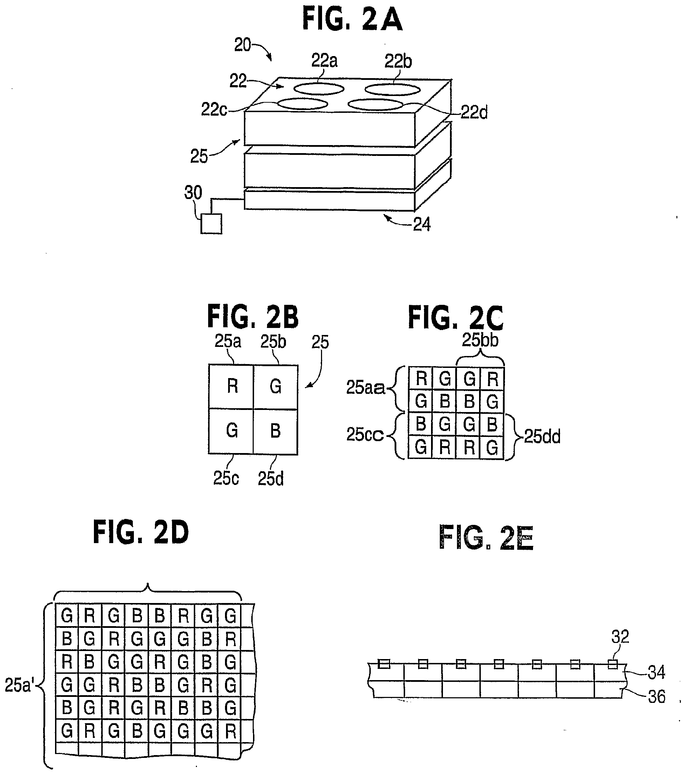

The general structure of a thin camera in accordance with an embodiment of the present invention is shown in FIG. 2A. A thin camera 20 includes an imaging lens array (ILA) 22, a color filter 25 and a detector array 24. The detector array 24 may be the same is in the conventional camera, and may include a microlens array, with a microlens corresponding to each pixel to improve the fill factor. As shown in the particular example of FIG. 2A, when the focal length of the conventional single lens is halved, D is also halved and the F# is maintained. In order to maintain the same field of view as in a conventional camera, a 2x2 array of lenses 22a-22d can be used with each lens addressing a quarter of the area of the sensor plane. Each combination of a lens 22a-22d, a color filter 25a-25d and corresponding portion of the detector array 24 constitutes a sub-camera. Thus, for the embodiment shown in FIG. 2A, there are a total of four sub-cameras. The images from each of the four sub-cameras are provided to a processor 30 where they are combined in a known manner to form a composite color image. The color filter 25 may be placed anywhere between the front of the camera and the sensor plane.

Here, rather than being driven only by thinness, the number of lenses or sub-cameras in the array is driven by a combination of several factors. First, the more lenses used, in general, the thinner the camera. However, it is a feature of an embodiment of the present invention is to achieve a resolution in the composite image equal or comparable to the total number of pixels in the image sensor without a great deal of computational signal processing. In order to achieve this, the point spread function (PSF) of the optics is preferably smaller than the pitch of the pixels on the sensor. The more lenses used, the more difficult recovery the full resolution of the sensor becomes. For example, if the sensor contains one million pixels, then the resolution of the image from each sub-camera is 250,000 pixels, assuming a tow by two ILA is used. However, it is a feature of an embodiment of this invention to produce a composite image with a resolution of or near one million, which means increasing the resolution by roughly a factor of four. For the two by two ILA, the size of the lens and the corresponding thickness of the sub-camera is half that of a conventional single lens camera, while being much more computationally straightforward than for a compound eye camera.

Exemplary embodiments of the color filter 25 to be used are shown in FIGS. 2B - 2D. The color filter 25 may have a different color filter 25a through 25d corresponding to each lens 22a through 22d, as shown in FIG. 2B. In particular, filter 25a may transmit red (R) light, filters 25b and 25c may transmit green (G) light, and filter 25d may transmit blue (B) light. Since each lens captures the entire image, a composite image can be realized by combining the images from each sub-camera. The composite image will have higher resolution that that of the individual sub-cameras. For example, in a conventional one megapixel, i.e. one million pixels, camera, there are 250,000 blue pixels, 250,000 red pixels and 500,000 green pixels. Each pixel samples light from a different portion of the image. Yet one million full color pixels are generated, typically by interpolation. If each image on each camera is identical, then there would be 250,000 red pixels of information, 250,000 blue pixels and 500,000 green pixels, 250,000 for each green sub-camera. So, there would be the same number of independent samples of information as in the conventional one megapixel camera for red and blue, but less for green, since the two green sub-cameras would be identical.

In one embodiment of the invention, the two green cameras may be distinguished from one another by placing apertures near the detector plane. By placing the apertures in different locations within the pixel, the two green sub-cameras will sample different portions of the image and thus generate 500,000 samples of information, rather than 250,000. There are several other ways to achieve this increase in information as well. Any method that will allow a different set of samples in the two green cameras achieves this increase. Other techniques include generating an image on the sensor plane for one green camera that is shifted slightly with respect to the other green camera, and using a combination of apertures and image shifting.

If apertures are to be used, one method of achieving this is to use the natural light blocking layers inherent in typical CMOS image sensors. CMOS image sensors typically have embedded circuitry that blocks a significant portion of the light incident on each pixel. For example, 25% -70% of the area of each pixel is typically blocked by this circuitry. In conventional cameras, micro-lens arrays (MLAs) are typically used to increase the efficiency of light capture by each pixel. In the conventional approach, the pitch of the lenses in the MLA is equal to the pitch of the pixels on the CMOS sensor chip, i.e., there is one micro-lens for each pixel. This approach typically improves the light capture efficiency of each pixel to approximately 75-85%. In accordance with an embodiment of the present invention, one way to achieve the light blocking apertures is to simply use the CMOS sensor chips without the micro-lenses, in the sub-cameras containing the green filters. As long as the two green images do not have identical registrations with respect to the pixels, the two green cameras will sample the image in different locations, i.e., different data will be generated by the two green cameras. If the two green camera images do have identical registrations with respect to the pixels, then circuit design can be modified on the image sensor chip so that the circuitry is blocking the light in different regions in the first green sub camera than in the second green sub camera.

In addition to using layers integrated on to the CMOS chip to block portions of the light, special MLAs can be used to shift the portions of the image that is detected by each pixel. For example the MLAs can be designed so that each micro-lens is slightly off-center of the active area of each pixel. In this manner a slightly different portion of the image is focused on to the active area of the sensor for the two green cameras.

Note that the MLAs can provide one shift for one camera and a different one for another camera. Or alternatively, each micro-lens within a sub-camera can provide a slightly different shift for every pixel, ensuring that the majority of the corresponding green pixels in the two green sub cameras receive different signals, for all ranges of object distance within the desired object distance range.

So the net result, is that four sub-cameras are used, i.e., one sub-camera is red, one sub-camera is blue and the other two sub cameras are green. When the composite image is formed, the red and blue resolution in the composite image is therefore the same as in the sub camera. However, the resolution for the composite image for the green color is increased over that of an individual camera, since information from the two individual cameras is combined to form a higher resolution composite image.

As mentioned above, there is no need to increase the resolution for the red and blue sub-cameras. Nevertheless, it may still be advantageous in some cases to use apertures and/or image shifting as described above for green, for the red and blue cameras, to, for example, sample the images in slightly different locations for the red and blue sub-cameras.

Since each lens captures the whole image, these color images may then be combined for full color with twice the resolution of a conventional color filter/pixel arrangement, i.e., simply using a Bayer pattern.

Alternatively, as shown in FIG. 2C, each lens 22a-22d may be assigned a different patterned color filter 25aa through 25dd, each lens being associated with a 4x4 color filter array. Since the position of the R and B filters are in different quadrants of the 4x4 array, and each lens captures the entire image, the color image may be realized. Again, there are twice as many G filters, here occupying each quadrant twice.

As another alternative, shown in FIG. 2D, a conventional color filter R-G-B color filter pattern can be used in which each pixel has a color filter associated therewith. In this case, if each camera captures identical images on the sensor plane, then the locations of the R, G and B filters need to be in different locations, for each camera. In any of the embodiments set forth in FIGS. 2B-2D, a quarter of the pixels generate N/4 sampling points of red, a quarter of the pixels generate N/4 samples of blue in the image and half of the pixels generate the N/2 samples of green. Any of the methods described above can be used to ensure that the N/2 samples of green are substantially independent.

In the above embodiments, there are still four cameras. In the first embodiment, each sub-camera images only one color. In the other two embodiments , there are multiple color filters for each sub-camera. However, in all the embodiments, for each pixel in the composite image, there are four corresponding pixel samples, one blue, one red and two green. In all of these approaches, each of these pixel samples originates from a different sub-camera. In the first approach all of the red pixels originate from one sub-camera. In the other approaches, the red pixel information is obtained from different sub-cameras for different pixels. One advantage of providing multiple colors for each sub-camera arises when the imaging range is relatively close to the camera, but target range of object distances is fairly large. Depending on the distance of the object from the camera, there will be a slightly different shift of the images on the sensors. There may be some locations of the image where the signals for both of the green cameras are nearly identical for certain regions. If this is the case then obtaining the green images from more cameras can improve the resolution of the image.

Any of the filters of FIGS. 2B - 2D may be combined with a mask for a pixel, as shown in FIG. 2E. For example, such a mask may have a plurality $n_x n_y$ of macro-pixels 34 of size $d_x d_y$, with one macro-pixel 34 for each sensor 36. Each macro-pixel 34 serves as a filter and has a feature 32. Each macro-pixel is between the ILA 22 and a detector array 24 (shown in Figure 2A) including a plurality of sensors 36. The macro-pixel size $d_x d_y$ may be the same as or greater than the pixel or sensor size $p_x p_y$. All or most of the light transmitted through each macro-pixel may be directed on to the corresponding sensor. The transmittance of each macro-pixel may vary across the macro-pixel. This variation in transmittance can be described by dividing the macro-pixel into micro-pixels, the transmittance of each of which may be uniform. Each macro-pixel 34 has m micro-pixels 32 of size q. More generally, there are $m_x$ micro-pixels 32 of a size $q_x$ in the x-direction and $m_y$ micro-pixels of size $q_y$ in the y-direction. Thus, the power incident on each sensor 36 is equal to a summation, over all micro-pixels 32 on the corresponding macro-pixel 34, of the power on each micro-pixel 32 multiplied by the transmittance of the micro-pixels.

Each micro-pixel may 32 either be open or closed, i.e., have a transmission of one or zero, and only one of the $m_x$ x $m_y$ micro-pixels 32 in each macro-pixel 34 may be open. For this case, consider $m_x = m_y = 10$, giving 100 micro-pixels 32 per macro-pixel 34. Also, consider the same sensor size of 20x20 microns as a conventional camera, and a f/1 lens with a 400 micron focal length. Then, the size of the lens is also 400 microns, e.g., the lens has a 400 micron diameter if it is spherical and a 400 micron width if it is square. Since the camera will be arrayed, it is desirable to limit the sensor elements 36 to within approximately the same dimensions as the lens size, so that there will be no dead space between lenses in the array. That limits the size of the sensor array to approximately 400 microns in diameter, and thus the number of sensors 36 to a 20x20 array. In this case, the resolution of the camera is now equal to $1/q_x$ x $1/q_y$. However, the result is a sampled image, i.e., the image would contain 20x20 samples of a 200x200 pixel image

The remaining pixels can be obtained by forming an array of micro-cameras, each including a micro-lens 22a, a plurality of sensors 36, and a plurality of macro-pixels 34 having a feature 32. The number of micro-lenses I may be different in the x-direction than the y-direction, i.e., $I_x$, $I_y$. The macro-pixels 34 may be located at an image plane of the micro-camera. The number $n_x$, $n_y$ of macro-pixels 34 and sensors 36 is determined by the selected size $p_x$, $p_y$ of the pixel and the size of the image at the image plane. All of these elements may be unitary devices, with the micro-cameras 30 being defined by individual micro-lenses 22. While the example above has an open micro-pixel of size q for each macro-pixel, as long as there are $n_x n_y$ sensors for the camera viewing each portion of the image with a filter having a feature with a desired minimum feature size q, the desired resolution may be realized. By combining the above color filter, half of the sub-pixels needed to increase the resolution as discussed above may be needed.

Alternatively to having a single micro-pixel shifted for each macro-pixel, multiple holes or micro-pixels may be open per macro-pixel. As noted above, when all of the micro-pixels in the array of micro-pixels are open, no light is blocked to the macro-pixel. If only one of the micro-pixels is open, the desired resolution is realized on the corresponding macro-pixel. Thus, the image can be decomposed by the micro-cameras in a variety of manners, as long as all of the information for each macro-pixel is captured. The ratio of the size of each macro-pixel to the size of each micro-pixel may be proportional to a number of micro-cameras in the thin camera. Some arrays of micro-pixels may allow all light in a macro-pixel to pass through, giving an average value of the intensity for that macro-pixel. Typically, most macro-pixels will have at least half of the micro-pixels open. Further, a gray scale approach, where each micro-pixel is assigned a transmittance that may vary between micro-pixels. Then, rather than referring to the micro-pixels as being open and closed, the macro-pixel would receive some level of transmittance. For example, at least 20% of the micro-pixels in a majority of the macro-pixels may have transmittances greater than 0.4

For small f/# lenses, it may be difficult to provide diffraction limited images over the field of view required. In this case it is sometimes easier to focus the light on to a curved surface. In this manner, the backside of the lens array could be etched into curved surfaces centered on each lens. Or the back surface could be etched in a series of discrete rings approximating a curved surface. The holes would then be provided on this curved or other non-flat surface. Providing the holes on a curved or other non-flat surface helps insure the image is diffraction limited across a wide field

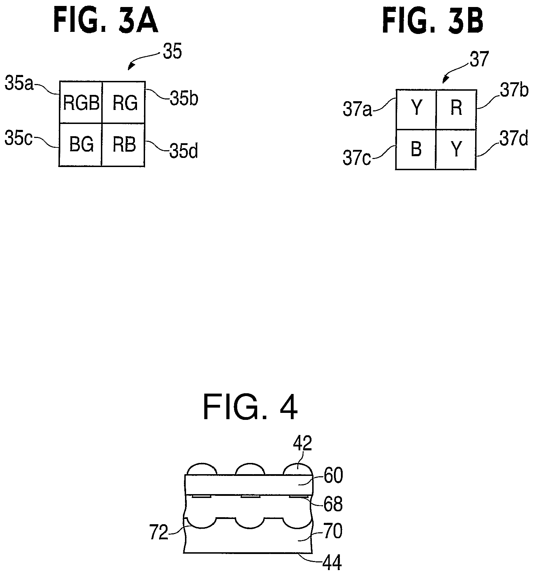

Other alternatives for realizing color images are shown in FIGS. 3A and 3B. Assuming four lenses are used, a filter 35 would include regions 35a through 35d. In the embodiment shown in FIG. 3A, at least two colors are provided on each pixel region. Region 35a transmits all light, i.e., has no filter, region 35b transmits red and green, region 35c transmits blue and green, and region 35d transmits red and blue. Region 35d may be eliminated, due to the green dominance realized by the other regions. If all four regions are used, then to determine the value of red simply subtract the power from a pixel in region 35c, from the corresponding pixel in region 35a. Similarly, the values for the other colors can also be obtained. Thus, only three lenses and associated filters are needed to realize full color, while maintaining green dominance. This also increases the amount of light incident on the detector plane. For example, using a conventional filter, 25% of red light, 25% of blue light and 50% of green light is transmitted. With the three filters noted above, approximately 67% of red light, 67% of blue light and 100% of green light is transmitted. If the same amount of power is to be incident on each detector, then some of the light in the most transmissive filter may be blocked to provide the shifting as noted above, while allowing the detectors to have the same gain.

Another alternate embodiment uses a color filter 37 shown in Fig. 3B, which uses the format established by the Joint Photographic Experts Group (JPEG). Again assuming four lenses are used, the filter 37 would include regions 37a through 37d. As shown in FIG. 3B, two of the regions 35a, 35d have a Y filter, region 35b has a R filter and region 35c has a B filter. In accordance with the JPEG standard, the YUV filters transmit in accordance with the following equation (1):

$$Y = 0.299R + 0.58G + 0.114B$$

$$U = B - Y$$
$$V = R - Y \qquad\qquad\qquad\qquad\qquad (1)$$

Thus, the YUV components may be determined from the filter 37 shown in FIG. 3B. The signal transmitted by the Y filter serves as the luminance. If more of the light needs to be transmitted, the proportions of the light transmitted by the Y filter could remain the same, while passing about all of the green light, about 0.51 of the red light, and about 0.2 of the blue light, with the remaining filters staying the same.

Typically, JPEG encoding has a higher number of Y samples. This fact may be used to improve the resolution of the camera. For example, by providing different information on the different Y regions, resolution can be improved. Such different information may be provided by blocking some of the light, shifting the image, or a combination thereof. If the point spread function (PSF) of the ILA is smaller than the pixel size, by focusing the light for one of the Y regions onto metal or other opaque material in the plane of the detector array to block some of the light will result in a differences between the images of the two Y regions. This may also be achieved by eliminating the microlens associated with each pixel to receive the altered image. To realize a shifted image, appropriate lenses in the ILA or microlenses for the detectors may be offset, i.e. to be off-axis. Thus, the resolution of the composite image will be determined by that of the Y image, with the other color images having a lower resolution. Again, since the Y filter allows more power through than the other filters, light can be blocked for this filter while equalizing power on the array of detectors.

The same approach may be used with the green filters for the red, blue, green configuration. Further, the shifting and/or blocking may be used in both Y regions. Additionally, the blocking may be realized using the apertures noted above. Finally, relative shifting of the blue and red images to each other may be used to improve the resolution of these images.

Increasing the number of lenslets in the ILA means that crosstalk becomes more of an issue. A light blocking element between the lenses themselves or between the lenses and the detector plane isolating light from the respective lenses may be used to minimize this crosstalk. Such a blocking element may be opaque or absorptive. These blocking elements may be in addition to or in place of conventional stops within the system. While keeping the same detector size, the lens size may be reduced to maintain the f/#, and the space between the lenses may include a blocking element. The use of smaller lenses with a low fill factor (e.g. sum of the area of the clear apertures of all the lenses less than 70% of the area of the sensor), in addition to reducing the focal length and maintaining the f/# of the system can be used to decrease cross talk, increase the field of view. While the fill factor of the lens array is then less than 100%, the detectors will still have a 100% fill factor.

In addition to or instead of having another optical element on the opposite surface of the substrate 60, a mask 68, as discussed above, may be provided on this surface, as shown in FIG. **4.** The alignment of the lenses 42 and the mask 62 may be readily realized, since they are on the same substrate 60. An additional substrate 70 including further optical elements 72 for imaging onto the detector plane 44 may be used. Here, since the mask is not between the optical elements 72 and the detector plane 44, the optical elements 72 may be of poor quality, e. g., having aberrations, while collecting all the light. The alignment of the mask 68 relative to the lenses 42 on the same substrate 60 is much more readily achieved than aligning the mask 68 to the detector plane 44. Further, this reduces the alignment requirements between the lenses 42 and the detector plane 44.

A specific example of a lens of the ILA to be used with the present invention is shown in 5A and 5B. In FIGS.

5A and 5B, the different light paths correspond to different field points from the object A first substrate 110 has a first refractive surface 112 which collimates the light input thereto. A second surface 114 of the first substrate may be planar and may include an infrared filter 115 thereon. A first surface 122 of an intermediate substrate 120 may have a diffractive element 123 thereon, which corrects for color and imaging aberrations. If each sub-camera has a single color filer, a single diffractive element 123 may be used for each sub-camera. A second surface 124 may have a second refractive surface for focuses the light A second substrate 130 has a refractive, concave surface 132 therein. The concave surface 132 flattens the field of the image, so that all image points are focused at the same plane 135 to be imaged onto the detector array 24.

In the above embodiments, to improve the resolution, the imaging of the two green sub-cameras should receive different images, If the object is located at infinity, the zero frequency pixel will be located at the center of each lens. Thus, to achieve the desired image shifts, the lenses in the ILA may be shifted relative to one another by an integer number of pixels plus 1/2 a pixel, in other words. The center to center spacing P between adjacent lenses in the ILA would be given by:

$$P = (N + 1/2) * x \qquad (2)$$

where x is the pixel pitch and N is an integer. For example, if each lens in the ILA has a diameter of 1 mm, x is 10 microns and N is selected to be 150, then the center to center spacing P is 1.505 mm.

If the object is not located at infinity, then an image pixel located under the center of one of the lenses will not be located under the center of an adjacent lens. Instead, it will be shifted by an amount s, given by:

$$s = P * di/do \qquad (3)$$

where di is the image distance, approximately equal to the focal length of the lens for most applications, i. e., when R=do/di is greater than 10, and do is the object distance. When the focal length is 2mm and assuming the pixel pitch x of 10 microns, the image shift s remains less than one tenth of a pixel for an object distance from infinity to approximately 3 m away. However, if the pixel pitch x is reduced to 3 microns, then when the object distance is 3, then s will be one-third of 1/3 of a pixel.

Although the images are located in different relative locations on the sub- camera pixels, depending upon the object distance, there is not an issue in terms of combining the wrong pixels when the composite image is generated. A relatively simple image processing algorithm can be used to determine the amount of shift needed to generate correlated images from different sub-cameras. However, at object locations where the image shift is closer to an integer number of pixels, instead of an integer plus ½, such interpolation becomes a problem, since such a shift would result in little or no difference between the images.

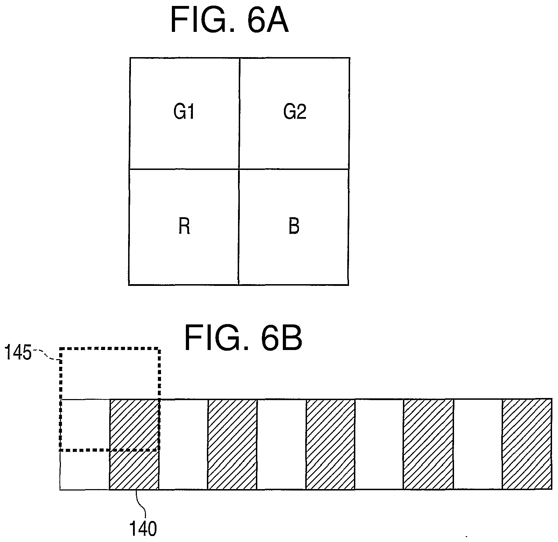

If a wide range of object distances is needed, one way to ensure different images from cameras with the same or similar color filters is to provide different optical elements in the paths thereof. For example, apertures, i.e., light blocking regions in the detector plane, maybe used. For example, one method to ensure different signals on the two green sub-cameras G1 and G2 is shown in Fig. 6B. In this embodiment, the G1 sub-camera has no apertures. Thus, the MLA for the G1 camera focuses nearly all the light in the sensor plane incident on a sensor pixel onto the active area of a pixel. On the G2 camera, a portion of the light on each pixel is blocked. In the example shown in FIG. 6B, the light on the left half of each pixel is blocked with an aperture 140. In addition, the lens centers of the two G1 and G2 cameras are placed very close to each other in the y-direction. That is the center co-ordinates of the centers of the lenses in the y-direction are offset by a small amount, e.g., by 0.5 pixels, or 1.5 microns for x=3 microns. Since the y-offset is so small, the shift in the image locations in the y-direction will be very small over a very wide range of object distances. For example if the y-offset is 1/3 of a pixel, then from equation (3), as long as R > 4, then the shift s will change by less than 1/12 of a pixel, from R=4 to R=infinity. Thus a shift of a known fraction of a pixel in the y-direction can be maintained for a wide range of object distances, ensuring that the two green cameras sample the image at different y locations. This will ensure an ability to use the two green camera images to increase the resolution in the y-direction. This resultant shift is indicated by a pixel 145 in the G2 camera in FIG. 6B.

To also increase the resolution in the x-direction, apertures are used on the G2 camera, blocking light directed on to the left side of each pixel in the G2 camera. As the object distance changes, the relative shift in the x-direction of the images on the two sub-cameras will change. Using apertures on one sub-camera, but not on the other sub-camera, or using different shaped apertures on the two sub-cameras, increased resolution in the x-direction can be achieved for any shift in the x-direction, as long as the relative shift is determined. For example, if the signals on the two cameras are aligned, then by subtracting the signal on the G2 camera from that of the G1 camera, one can determine the signal on the left side of each pixel, since the G2 signal itself returns the average value of the right half of each pixel. If the image shifts by ½ of a pixel, then the G2 signal will return the left half of each pixel and subtraction will yield the right half of each pixel. If the image shifts by ¼ of a pixel, then the G2 signal returns a signal at the midway point between the samples of the G1 signals. If the image shifts by % of a pixel then the centers of the G1 and G2 signals are aligned in the x-direction. However, by subtracting the corresponding G1 and G2 pixels and using interpolation algorithms, again increased resolution can be achieved. For example, for the ith pixel, if the G1 signal is subtracted from the G2 signal, the result is the sum of the left ¼ pixel and right ¼ pixel. By approximating the left ¼ pixel value to be the same as the previous pixel's right ¼ pixel value, or a weighted average sum of its closest neighboring samples, then the right ¼ pixel value can be determined.

This embodiment ensures that each pixel in the G1 and G2 sub-cameras will be centered at different locations in both the x and y directions. For example, if there are N/4 pixels in the G1 sub-camera and N/4 pixels for the G2 sub-camera, there will by N/2 unique green images. Lenses for red and blue cameras R, B, may be offset along y-direction for the example in FIG. 6A. The above problem of different object distances resulting in integer multiple of pixel shifts may arise. However, since in general higher resolution is more apparent in green than in red or blue, such decrease in resolution may not be of concern. If it is, then aperture could similarly be employed in either the red or blue sub-camera. Further, the above solution is also applicable when using Y, U, V sub-cameras, discussed above in connection with FIG. 3B.

**Claims**

1.  A color camera (20) comprising:
    at least three sub-cameras, each sub-camera including:

    an imaging system including a lens system having

    a first substrate (110) having a convex refractive element (112) for collimating light;
    a second substrate (130) having a concave refractive element (132) for flattening the field of an image; and
    a separation between the first substrate (110) and the second substrate (130), the separation between the convex refractive element (112) and the concave refractive element (132) including an air gap,

    a color filter (25), and
    a portion of a detector array (24), the concave refractive element (132) being closer to the detector array (24) than the convex refractive element (112) and
    means (30) configured for combining images from the at least three sub-cameras to form a composite multi-color image, wherein the at least three sub-cameras include a total number N of portions of said detector array and a total number X of different color sets, wherein a first number of signals of a first color set is less than N/X and a second number of signals of a second color set is greater than N/X, signals of the second color set being output from at least two of the at least three sub-cameras, wherein a resolution of a composite image of the second color set is greater than a resolution of an individual sub-camera and a resolution of the composite image of the first color set is no greater than that of an individual sub-camera.

**Patentansprüche**

1.  Farbkamera (20), Folgendes umfassend:
    wenigstens drei Subkameras, wobei jede Subkamera Folgendes beinhaltet:

    ein Abbildungssystem, das ein Linsensystem beinhaltet, das ein erstes Substrat (110) aufweist, das ein konvexes Brechungselement (112) zum Kollimieren von Licht aufweist;
    ein zweites Substrat (130), das ein konkaves Brechungselement (132) zum Abflachen des Feldes eines Bildes aufweist; und
    eine Trennung zwischen dem ersten Substrat (110) und dem zweiten Substrat (130), wobei die Trennung zwischen dem konvexen Brechungselement (112) und dem konkaven Brechungselement (132) einen Luftspalt, einen Farbfilter (25) und einen Abschnitt einer Detektormatrix (24) beinhaltet, wobei das konkave Brechungselement (132) näher an der Detektormatrix (24) als das konvexe Brechungselement (112) liegt und ein Mittel (30), das zum Kombinieren von Bildern von den wenigstens drei Subkameras konfiguriert ist, um ein zusammengesetztes Mehrfarbenbild auszubilden, wobei die wenigstens drei Subkameras eine Gesamtanzahl N von Abschnitten der Detektormatrix und eine Gesamtanzahl X von verschiedenen Farbsätzen beinhalten, wobei eine erste Anzahl von Signalen eines ersten Farbsatzes unter N/X liegt und eine zweite Anzahl von Signalen eines zweiten Farbsatzes über N/X liegt, wobei Signale des zweiten Farbsatzes von wenigstens zwei der wenigstens drei Subkameras ausgegeben werden, wobei eine Auflösung eines zusammengesetzten Bildes des zweiten Farbsatzes über einer Auflösung einer individuellen Subkamera liegt und eine Auflösung des zusammengesetzten Bildes des ersten Farbsatzes höchstens bei der einer einzelnen Subkamera liegt.

**Revendications**

1.  Caméra couleur (20) comprenant :
    au moins trois sous-caméras, chaque sous-caméra comportant :

    un système d'imagerie comportant un système de lentilles ayant

    un premier substrat (110) ayant un élément de réfraction convexe (112) pour collimater la lumière ;
    un second substrat (130) ayant un élément de réfraction concave (132) pour aplatir le champ d'une image ; et
    une séparation entre le premier substrat (110) et le second substrat (130), la séparation entre l'élément de réfraction convexe (112) et l'élément de réfraction concave (132) comportant un espace d'air,

    un filtre coloré (25) et
    une partie d'un réseau de détecteurs (24),
    l'élément de réfraction concave (132) étant plus proche du réseau de détecteurs (24) que l'élément de réfraction convexe (112) et
    des moyens (30) configurés pour combiner les images des au moins trois sous-caméras afin de former une image polychrome composite, les au moins trois sous-caméras comportant un nombre total N de parties dudit réseau de détecteurs et un nombre total X de jeux de couleurs différents,
    un premier nombre de signaux d'un premier jeu de couleurs étant inférieur à N/X et un second nombre de signaux d'un second jeu de couleurs étant supérieur à N/X, les signaux du second jeu de couleurs étant émis par au moins deux des au moins trois sous-caméras, une résolution d'une image composite du second jeu de couleurs étant supérieure à la résolution d'une sous-caméra individuelle et une résolution de l'image composite du premier jeu de couleurs n'étant pas supérieure à celle d'une sous-caméra individuelle.

## FIG. 1A

12
10
15
14

## FIG. 1B

| G | R | G | R | G | R |
|---|---|---|---|---|---|
| B | G | B | G | B | G |
| G | R | G | R | G |   |
| B | G | B | G | B |   |

15

## FIG. 1C

15'

| G | R | G |
|---|---|---|
| B | G | B |

EP 1 712 087 B1

# FIG. 2A

# FIG. 2B

# FIG. 2C

# FIG. 2D

# FIG. 2E

## FIG. 3A

35a — RGB | RG — 35b
35c — BG | RB — 35d

35

## FIG. 3B

37a — Y | R — 37b
37c — B | Y — 37d

37

## FIG. 4

42
60
68
72
70
44

EP 1 712 087 B1

FIG. 5A

FIG. 5B

EP 1 712 087 B1

# FIG. 6A

| | |
|---|---|
| G1 | G2 |
| R | B |

# FIG. 6B

145

140

EP 1 712 087 B1

**EP 1 712 087 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002122124 A1
- EP 1348990 A1
- GB 2320837 A